# EUROPEAN PATENT SPECIFICATION

(11) **EP 2 467 006 B1**
(45) Date of publication and mention of the grant of the patent: **07.01.2015**
(21) Application number: 10813358.8
(22) Date of filing: 03.09.2010
(51) Int. Cl.: H05K 7/20

(54) **REMOTE RADIO UNIT**
FERNFUNKEINHEIT
UNITÉ RADIO DISTANTE

(30) Priority: 03.09.2009 CN 200910170152
(43) Date of publication of application: 20.06.2012
(73) Proprietor: Huawei Technologies Co., Ltd., Guangdong 518129 (CN)
(72) Inventor: LI, Zhijian, Shenzhen Guangdong 518129 (CN); FENG, Taqing, Shenzhen Guangdong 518129 (CN); HONG, Yuping, Shenzhen Guangdong 518129 (CN); SHI, Jian, Shenzhen Guangdong 518129 (CN)
(74) Representative: Thun, Clemens
(86) International application number: PCT/CN2010/076593
(87) International publication number: WO 2011/026436

(56) References cited:
- WO-A2-2006/063277
- CN-A- 1 703 142
- CN-A- 101 013 011
- CN-A- 101 645 714
- CN-Y- 201 197 257
- CN-Y- 201 197 257
- JP-A- 2007 315 740
- US-A1- 2003 016 499
- US-B1- 6 388 882
- US-B1- 6 827 132

## Description

### FIELD OF THE INVENTION

The present invention relates to a communication device, and in particular, to a Remote Radio Unit (RRU)

### BACKGROUND OF THE INVENTION

An RRU is a novel disposed network coverage mode, in the mode, high-capacity macro cell base stations are centrally placed in an accessible central equipment room, baseband parts are processed centrally, and radio frequency modules in a base station is pulled to the RRU by adopting optical fibers, and are separately placed on stations determined by the network planning, thereby saving a large quantity of equipment rooms required by the regular solution; and meanwhile, by adopting a high-capacity macro base station to support pulling a large quantity of optical fibers far away, the conversion between the capacity and the coverage may be achieved. Because of the foregoing advantages of the RRU, the RRU is widely applied.

An existing RRU having a shell includes an RRU radiator structural member and a shell; the RRU radiator structural member includes an RRU and a radiator, a radiating portion of the RRU is connected to the radiator, the radiating portion of the RRU specifically may be a power amplifier module, a duplexer module, or a transceiver module of the RRU, and the radiator includes radiating fins configured to exchange heat with the air so as to achieve radiating. The shell surrounds the RRU and the radiator, and the shell is made of a plastic material, and is connected to the RRU radiator structural member through screws, which functions to be aesthetic and prevent solar radiation.

In the research for the prior art, the inventors find that: the existing RRU only uses the radiating fins of the radiator to perform heat exchange with the air to achieve radiating, and therefore, overall system radiating efficiency is not high.

CN 201 197 257 Y shows a heat dissipating device that comprises a radiator, a fan, and a cover with a solar battery, in which the radiating ability is implemented by arranging the fan opposite to the radiator and providing the fan with power supply through the solar battery.

US 6,388,882 B1 shows a thermal energy management architecture that comprises several levels of heat transfer devices, in which the fourth level of heat transfer devices comprise means for busing thermal energy that are thermally driven and operatively engaged with at least one of first to four levels of heat transfer devices.

### SUMMARY OF THE INVENTION

An embodiment of the present invention provides an RRU, which is capable of improving radiating efficiency.

An RRU includes an RRU radiator structural member and a shell, the shell includes an evaporator, radiating pipes and a shell body, the inside of the evaporator is in communication with the radiating pipes to form a loop for holding a phase change medium, and the radiating pipes are disposed on the shell body for transferring heat to the shell; and
the evaporator is connected to a radiator of the RRU radiator structural member.

It may be seen from the foregoing technical solutions according to the embodiments of the present invention that, in the embodiments of the present invention, the evaporator included by the shell in the RRU is connected to the radiator of the RRU radiator structural member, so the heat of the radiator can be transferred to the evaporator, and the heat may be further transferred to the shell through the radiating pipes since the evaporator is connected to the radiating pipes, so that the shell participates in the radiating, thereby improving the radiating efficiency and improving the work stability of the RRU.

### BRIEF DESCRIPTION OF THE DRAWINGS

To illustrate the technical solutions according to the embodiments of the present invention or in the prior art more clearly, the accompanying drawings for describing the present invention or the prior art are introduced briefly in the following. Apparently, the accompanying drawings in the following description are only about some embodiments of the present invention, and person of ordinary skill in the art can derive other drawings from the accompanying drawings without creative efforts.
FIG 1 is a structural diagram of an RRU according to an embodiment of the present invention; and
FIG. 2 is a structural diagram of a shell in the RRU according to the embodiment of the present invention.

### DETAILED DESCRIPTION OF THE EMBODIMENTS

The technical solutions according to the embodiments of the present invention will be clearly described in the following with reference to the accompanying drawings. It is obvious that the embodiments to be described are only a part rather than all of the embodiments of the present invention. All other embodiments obtained by persons skilled in the art based on the embodiments of the present invention without creative effects shall fall within the protection scope of the present invention.

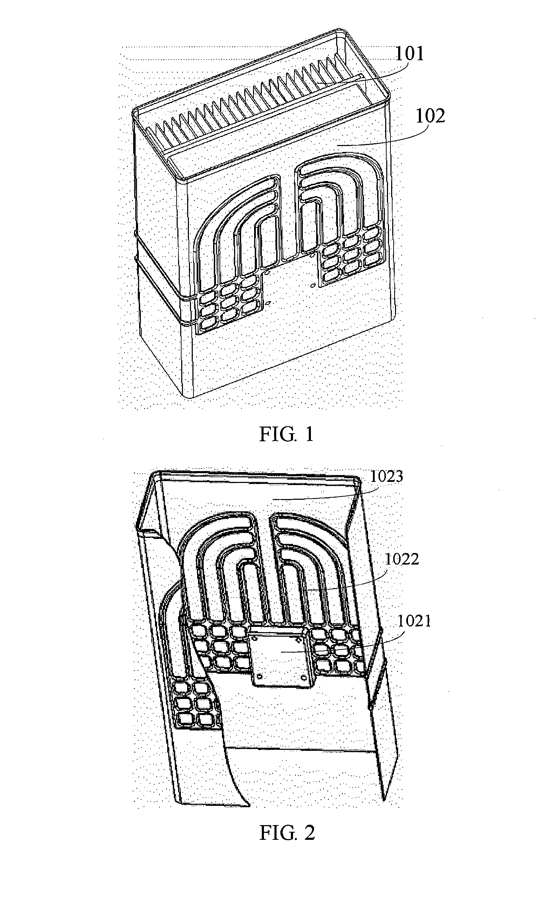

FIG 1 describes an RRU according to an embodiment of the present invention, which includes an RRU radiator structural member 101 and a shell 102.

The structure of the shell 102 is shown in FIG 2, and the shell 102 includes an evaporator 1021, radiating pipes 1022 and a shell body 1023.

The inside of the evaporator 1021 is in communication with the radiating pipes 1022, and the radiating pipes 1022 are disposed on a surface of the shell body 1023.

The radiating pipes 1022 may be made of a metal material, for example, metal with good heat conducting performance such as copper and aluminum; and may also be made of a plastic material, such as heat conducting plastic. The material of the shell body 1023 may be the same as the material of the radiating pipes 1022, and may also be different from the material of the radiating pipes 1022. The length and the shape of the radiating pipes 1022 may be designed or assembled as required.

The evaporator 1021 may be fixed on the shell body 1023; for example, the evaporator 1021 may be fixed on the shell body 1023 by adopting screws or buckles, thereby ensuring that the evaporator 1021 is tightly connected to the shell body 1023.

The evaporator 1021 is connected to a radiator of the RRU radiator structural member 101.

It may be seen from the foregoing description that, the evaporator included by the shell in the RRU according to the embodiment of the present invention is connected to the radiator of the RRU radiator structural member, so that the heat of the radiator can be transferred to the evaporator, and the heat may be further transferred through the radiating pipes since the evaporator is connected to the radiating pipes, thereby improving the radiating efficiency and improving the work stability of the RRU.

In an embodiment of the present invention, in order to enable the evaporator to maintain the position fixed after the evaporator is connected to the radiator, the evaporator may be locked through screws, thereby ensuring that the heat of the radiator can be transferred to the evaporator.

Further, a groove is disposed in the evaporator 1021, so that the groove may be in communication with the radiating pipes 1022 to form a loop, thereby further improving the heat conduction efficiency.

A phase changeable medium may be filled in the radiating pipes 1022, and the medium may be a medium having an efficient phase change heat exchange capability such as water, ammonia, or Freon^{®}.

After the phase changeable medium is filled in the radiating pipes 1022, the heat may be transferred in the radiating pipes through the phase changeable medium, and then the radiating is performed through the radiating pipes; further, when the radiating pipes are in communication with the groove of the evaporator to form the loop, the heat may be transferred more quickly between the evaporator and the radiating pipes through the phase changeable medium, thereby improving the radiating efficiency.

In an embodiment of the present invention, the radiating pipes 1022 may be embedded in the shell body 1023, so the radiating pipes 1022 and the shell body 1023 may be manufactured through integral molding; for example, when the shell body 1023 is made of the plastic material, the blow-up process may be performed on the shell body 1023 to form the radiating pipes 1022, and in this case, the radiating pipes 1022 is also made of the plastic material; or when the shell body 1023 is made of the plastic material, and the radiating pipes 1022 is made of the metal material, the injection molding may be performed on the radiating pipes 1022.

Alternatively, the radiating pipes 1022 may not be embedded in the shell body 1023, and in this case, the radiating pipes 1022 and the evaporator 1021 may be located at two sides of a surface of the shell body 1023 respectively. The radiating pipes 1022 and the shell body 1023 may be respectively machined, and then are assembled with the evaporator 1021 to form the shell 102; compared with the practice that the radiating pipes 1022 and the shell body 1023 are manufactured through the integral molding, the foregoing practice may reduce the machining difficulty and the manufacturing cost, and meanwhile the design flexibility may also be improved.

In an embodiment of the present invention, in order to further improve the radiating efficiency of the RRU, a ventilation hole may be opened on the shell body 1023, thereby satisfying requirements of the RRU for the ventilation quantity under different environments.

It can be easily understood that, for better radiating, and for convenience of the circulation of the phase change material in the evaporator and the radiating pipes, the horizontal position of the radiator is not higher than that of the radiating pipes, that is to say, the horizontal position of the radiator is lower than or horizontal to that of the radiating pipes. Definitely, in the case that the radiating efficiency is not taken into consideration, or the gasified medium generated by the evaporator can provide a sufficient acting force to enable the phase change medium to flow in the loop formed by the evaporator and the radiating pipes, or additional power elements are mounted in the radiating pipes, the evaporator may also be higher than the radiating pipes.

An RRU according to the embodiments of the present invention is introduced in detail in the foregoing, and the illustration of the foregoing embodiments is only used to help in understanding the method and the idea of the present invention. Meanwhile, persons of ordinary skill in the art can make variations and modifications to the present invention in terms of the specific implementations and application scopes according to the ideas of the present invention. Therefore, the specification shall not be construed as limitations to the present invention.

## Claims

1. A Remote Radio Unit, hereinafter referred to as RRV, comprising an RRU radiator structural member (101) and a shell (102),
**characterized in that**
the shell (102) comprises an evaporator (1021), radiating pipes (1022) and a shell body (1023), the inside of the evaporator (1021) is in communication with the radiating pipes (1022) to form a loop for holding a phase change medium, and the radiating pipes (1022) are disposed on the shell body (1023) for transferring heat to the shell (102); and
the evaporator (1021) is connected to a radiator of the RRU radiator structural member (101).

2. The RRU according to claim 1, **characterized in that** a groove exists in the evaporator (1021), and the groove is in communication with the radiating pipes (1022) to form a loop.

3. The RRU according to claim 1 or 2, **characterized in that** a phase changeable medium is filled in the radiating pipes (1022).

4. The RRU according to claim 3, **characterized in that** the phase changeable medium is water or ammonia.

5. The RRU according to claim 1 or 2, **characterized in that** the radiating pipes (1022) are embedded in the shell body (1023); or
the radiating pipes (1022) are disposed on the outside of the shell body (1023).

6. The RRU according to claim 1 or 2, **characterized in that** the shell body (1023) is made of a plastic material, and the radiating pipes (1022) are made of a metal material; or
the shell body (1023) is made of a plastic material, and the radiating pipes (1022) are made of a plastic material; or
the shell body (1023) is made of a metal material, and the radiating pipes (1022) are made of a metal material; or
the shell body (1023) is made of a metal material, and the radiating pipes (1022) are made of a plastic material.

7. The RRU according to claim 6, **characterized in that** the metal material is copper or aluminum.

8. The RRU according to claim 6, **characterized in that** the plastic material is heat conducting plastic.

9. The RRU according to claim 1 or 2, **characterized in that** the shell body (1023) is opened with a ventilation hole.

10. The RRU according to claim 1, **characterized in that** the horizontal position of the evaporator (1021) is horizontal to or lower than that of the radiating pipes (1022).

## Patentansprüche

1. Fernfunkeinheit, im Folgenden kurz RRU, umfassend ein RRU-Kühlerstrukturelement (101) und eine Schale (102),
**dadurch gekennzeichnet, dass**
die Schale (102) einen Verdampfer (1021), Strahlungsrohrleitungen (1022) und einen Schalenkörper (1023) umfasst, wobei die Innenseite des Verdampfers (1021) in Verbindung mit den Strahlungsrohrleitungen (1022) steht, um eine Schlaufe zum Halten eines Phasenänderungsmediums zu bilden und die Strahlungsrohrleitungen (1022) am Schalenkörper (1023) zum Übertragen von Wärme an die Schale (102) angeordnet sind; und
der Verdampfer (1021) mit einem Kühler des RRU-Kühlerstrukturelements (101) verbunden ist.

2. RRU nach Anspruch 1, **dadurch gekennzeichnet, dass** eine Nut in dem Verdampfer (1021) vorliegt und die Nut in Verbindung mit den Strahlungsrohrleitungen (1022) steht, um eine Schlaufe zu bilden.

3. RRU nach Anspruch 1 oder 2, **dadurch gekennzeichnet, dass** ein phasenveränderbares Medium in die Strahlungsrohrleitungen (1022) gefüllt wird.

4. RRU nach Anspruch 3, **dadurch gekennzeichnet, dass** das phasenveränderbare Medium Wasser oder Ammoniak ist.

5. RRU nach Anspruch 1 oder 2, **dadurch gekennzeichnet, dass** die Strahlungsrohrleitungen (1022) im Schalenkörper (1023) eingebettet sind;
oder die Strahlungsrohrleitungen (1022) auf der Außenseite des Schalenkörpers (1023) angeordnet sind.

6. RRU nach Anspruch 1 oder 2, **dadurch gekennzeichnet, dass** der Schalenkörper (1023) aus einem Kunststoffmaterial hergestellt ist, und dadurch, dass die Strahlungsrohrleitungen (1022) aus einem Metallmaterial hergestellt sind; oder
der Schalenkörper (1023) aus einem Kunststoffmaterial hergestellt ist, und die Strahlungsrohrleitungen (1022) aus einem Kunststoffmaterial hergestellt sind; oder
der Schalenkörper (1023) aus einem Metallmaterial hergestellt ist, und die Strahlungsrohrleitungen (1022) aus einem Metallmaterial hergestellt sind; oder
der Schalenkörper (1023) aus einem Metallmaterial hergestellt ist, und die Strahlungsrohrleitungen (1022) aus einem Kunststoffmaterial hergestellt sind.

7. RRU nach Anspruch 6, **dadurch gekennzeichnet, dass** das Metallmaterial Kupfer oder Aluminium ist.

8. RRU nach Anspruch 6, **dadurch gekennzeichnet, dass** das Kunststoffmaterial wärmeleitender Kunststoff ist.

9. RRU nach Anspruch 1 oder 2, **dadurch gekennzeichnet, dass** der Schalenkörper (1023) mit einem Belüftungsloch geöffnet wird.

10. RRU nach Anspruch 1, **dadurch gekennzeichnet, dass** die horizontale Position des Verdampfers (1021) horizontal zu der oder niedriger als die Position der Strahlungsrohrleitungen (1022) ist.

## Revendications

1. Unité radio distante (dénommée ci-après RRU), comportant un organe structural de radiateur de RRU (101) et une coque (102),
**caractérisée en ce que**
la coque (102) comprend un évaporateur (1021), des tubes radiants (1022) et un corps de coque (1023), l'intérieur de l'évaporateur (1021) étant en communication avec les tubes radiants (1022) pour former une boucle pour contenir un milieu à changement de phase, et les tubes radiants (1022) sont disposés sur le corps de coque (1023) pour transférer de la chaleur à la coque (102) ; et
l'évaporateur (1021) est connecté à un radiateur de l'organe structural de radiateur de RRU (101).

2. RRU selon la revendication 1, **caractérisée en ce qu'**une rainure existe dans l'évaporateur (1021), et la rainure est en communication avec les tubes radiants (1022) pour former une boucle.

3. RRU selon la revendication 1 ou 2, **caractérisée en ce qu'**un milieu à changement de phase remplit les tubes radiants (1022).

4. RRU selon la revendication 3, **caractérisée en ce que** le milieu à changement de phase est de l'eau ou de l'ammoniac.

5. RRU selon la revendication 1 ou 2, **caractérisée en ce que** les tubes radiants (1022) sont encastrés dans le corps de coque (1023) ; ou
les tubes radiants (1022) sont disposés sur l'extérieur du corps de coque (1023).

6. RRU selon la revendication 1 ou 2, **caractérisée en ce que** le corps de coque (1023) est constitué d'un matériau plastique, et les tubes radiants (1022) sont constitués d'un matériau métallique ; ou
le corps de coque (1023) est constitué d'un matériau plastique, et les tubes radiants (1022) sont constitués d'un matériau plastique ; ou
le corps de coque (1023) est constitué d'un matériau métallique, et les tubes radiants (1022) sont constitués d'un matériau métallique ; ou
le corps de coque (1023) est constitué d'un matériau métallique, et les tubes radiants (1022) sont constitués d'un matériau plastique.

7. RRU selon la revendication 6, **caractérisée en ce que** le matériau métallique est du cuivre ou de l'aluminium.

8. RRU selon la revendication 6, **caractérisée en ce que** le matériau plastique est un plastique conducteur de la chaleur.

9. RRU selon la revendication 1 ou 2, **caractérisée en ce que** le corps de coque (1023) est ouvert avec un trou de ventilation.

10. RRU selon la revendication 1, **caractérisée en ce que** la position horizontale de l'évaporateur (1021) est horizontale à par rapport ou plus basse que celle des tubes radiants (1022).
